# EUROPÄISCHE PATENTSCHRIFT

(11) **EP 0 848 499 B1**
(45) Veröffentlichungstag und Bekanntmachung des Hinweises auf die Patenterteilung: **21.05.2003**
(21) Anmeldenummer: 97203786.5
(22) Anmeldetag: 03.12.1997
(51) Int. Cl.: H03M 1/66, H03K 3/286

(54) **Schaltungsanordnung für eine Speicherzelle eines D/A-Wandlers**
Circuit arrangement for a memory cell in a D/A converter
Agencement de circuit pour une cellule de mémoire d'un convertisseur N/A

(30) Priorität: 13.12.1996 DE 19651921
(43) Veröffentlichungstag der Anmeldung: 17.06.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Kordts, Jürgen, Röntgenstrasse 24, 22335 Hamburg (DE); Hahn, Friedrich, Röntgenstrasse 24, 22335 Hamburg (DE); Rolla, Peter, Röntgenstrasse 24, 22335 Hamburg (DE); Beier, Ralf, Röntgenstrasse 24, 22335 Hamburg (DE); Nähte, Axel, Röntgenstrasse 24, 22335 Hamburg (DE)
(74) Vertreter: Peters, Carl Heinrich, Dipl.-Ing.

(56) Entgegenhaltungen:
- US-A- 4 210 830
- US-A- 4 383 248
- US-A- 4 563 669

## Beschreibung

Die Erfindung bezieht sich auf eine Schaltungsanordnung für eine Speicherzelle eines D/A-Wandlers und insbesondere auf eine Speicherzelle, in der ein analoger Strom durch ein gespeichertes digitales Signal geschaltet wird.

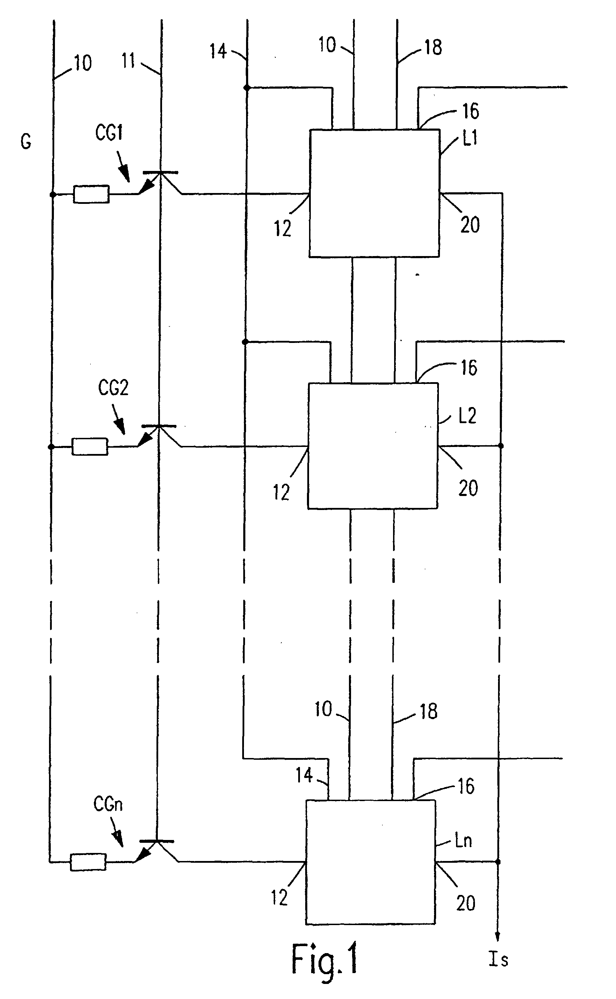

Eine sehr häufig verwendete Art von D/A-Wandlern umfaßt eine Anzahl Stufen, denen von Stromgeneratoren Ströme mit binär gestuften Werten zugeführt werden, und abhängig von einem in der Stufe gespeicherten binären Wert wird dieser zugeführte Strom an einen Ausgang weitergeleitet oder abgeleitet bzw. einem anderen Ausgang zugeleitet. Ein Beispiel für einen solchen D/A-Wandler ist in Fig. 1 dargestellt und umfaßt eine Anzahl Stufen L1, L2 bis Ln sowie eine Anzahl Stromgeneratoren CG1, CG2 bis CGn. Jeder Stromgenerator umfaßt die Reihenschaltung eines Widerstandes und eines Transistors, wobei das eine Ende des Widerstandes mit einer Leitung 10 für eine Bezugsspannung, d.h. allgemein mit Masse, und die Basen aller Transistoren mit einer Leitung 11 für eine Hilfsspannung verbunden sind. Die Widerstände sind so dimensioniert, daß im Kollektor des Transistors eines Stromgenerators ein Strom mit dem doppelten Wert wie in dem vorhergehenden Stromgenerator fließt. Diese Ströme werden einem Stromeingang 12 einer zugehörigen Stufe L1, L2 bis Ln zugeführt, die diesen Strom abhängig von einem darin gespeicherten digitalen Wert an einem Stromausgang 20 abgibt, wobei alle Stromausgänge miteinander verbunden sind und somit einen Summenstrom Is liefern. Die in den einzelnen Stufen gespeicherten binären Werte werden vorher über einen Dateneingang 16 zugeführt und durch ein Signal auf einer Steuerleitung 14 in die Stufen eingeschrieben.

Wenn ein solcher D/A-Wandler in einem Halbleiter zusammen mit weiteren analogen Schaltungen integriert werden soll, wird dafür häufig ein Herstellungsprozeß verwendet, in dem nur analoge Schaltungen, jedoch keine digitalen Schaltungen sinnvoll hergestellt werden können, so daß digitale Schaltungen mit analogen Mitteln realisiert werden müssen. Dies gilt insbesondere, wenn die verwendete Integrationstechnik auch nicht die Herstellung von Schaltungen in IIL-Technik erlaubt.

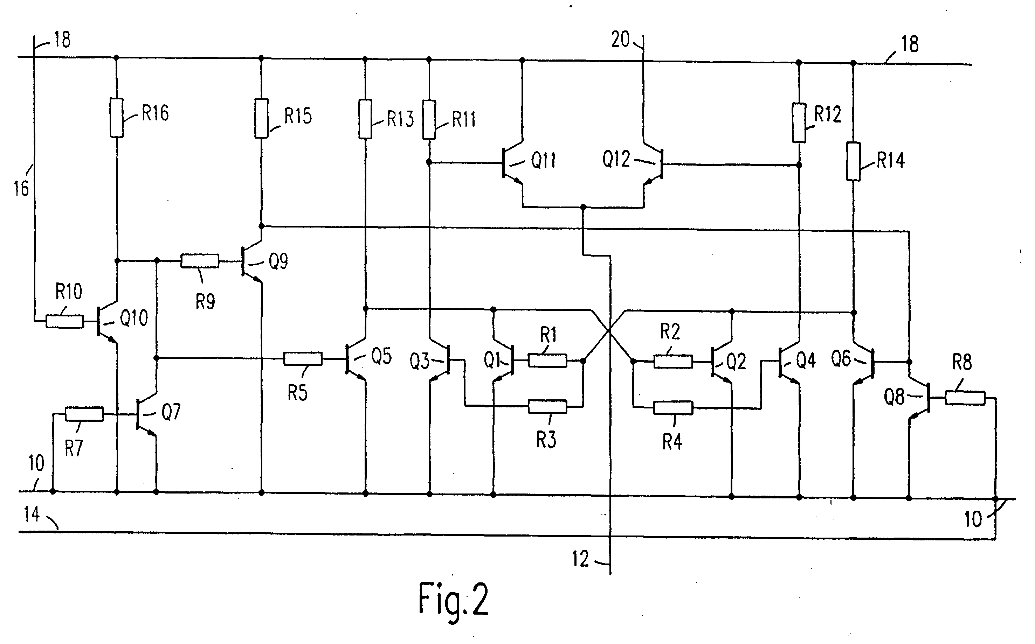

Die Fig. 2 zeigt eine Schaltungsanordnung für eine Speicherzelle eines D/A-Wandlers entsprechend einer der Stufen L1, L2 usw. in Fig. 1, die in konventioneller analoger Technik aufgebaut ist. Der einem Stromeingang 12 zugeführte analoge Strom wird den Emittern von zwei Transistoren Q11 und Q12 zugeführt, deren Basen mit unterschiedlichen Spannungen angesteuert werden, so daß der zugeführte Strom entweder vollständig über den Ausgang 20 herausgeführt oder über eine mit Betriebsspannung verbundene Leitung 18 abgeführt wird. Die Transistoren Q11 und Q12 wirken somit als Schalter, der über ein Flipflop angesteuert wird, das aus den Transistoren Q1 und Q2 gebildet wird, die kreuzgekoppelt sind, indem die Basis jedes dieser Transistoren über einen Widerstand R1 bzw. R2 mit dem Kollektor des jeweils anderen Transistors verbunden ist.

Durch die zu den Transistoren Q1 bzw. Q2 über die Widerstände R3 und R4 parallelgeschalteten Transistoren Q3 bzw. Q4 und die mit deren Kollektoren verbundenen Widerstände R11 und R12 werden die den Schalter bildenden Transistoren Q11 und Q12 gesteuert. Bei parallelgeschalteten Basisanschlüssen sind aus Stromaufteilungsgründen immer Widerstände in den Basisleitungen erforderlich. Über die Widerstände R14 und R15, die an die Leitung 18 für die Versorgungsspannung angeschlossen sind, wird das Flipflop mit Strom versorgt. Parallel zu den Transistoren Q1 und Q2 des Flipflops sind Transistoren Q5 und Q6 geschaltet, über die der binäre Wert im Flipflop eingestellt werden kann. Dafür ist die Basis des Transistors Q5 über einen Widerstand R5 mit den Kollektoren zweier weiterer Transistoren Q7 und Q10 verbunden, die über einen weiteren Widerstand R9 mit einem weiteren Transistor Q9 und über einen Widerstand R16 mit der Leitung 18 verbunden sind. Der Kollektor des Transistors Q9 ist mit einem Widerstand R15 mit der Leitung 18 sowie mit der Basis des Transistors Q6 und dem Kollektor eines Transistors Q8 verbunden. Die Basen der Transistoren Q7 und Q8 sind über je einen Widerstand R7 und R8 mit dem Steuereingang 14 verbunden, und der Transistor Q10 ist über einen Widerstand R10 mit dem Dateneingang 16 verbunden. Solange der Steuereingang 14 hohes Potential führt, sind die Transistoren Q7 und Q8 leitend und damit die Transistoren Q5 und Q6 gesperrt, so daß der Zustand des Flipflops nicht beeinflußt wird. Wenn der Steuereingang 14 niedriges Potential hat, sind die Transistoren Q7 und Q8 gesperrt, und abhängig vom Signal am Dateneingang 16 ist der Transistor Q9 oder Q10 gesperrt und somit der Transistor Q5 oder Q6 leitend, wodurch das Flipflop auf den am Dateneingang 16 anliegenden binären Wert eingestellt wird.

Nachteilig an dieser Schaltung ist, daß viele Komponenten benötigt werden und die Integration flächenaufwendig wird, da die Transistoren in getrennten Inseln realisiert werden müssen. Weiterhin sind die Verzögerungszeiten dieser Schaltung nicht optimal, da beim Aktivieren des Steuereingangs 14 jeweils zwei Transistorverzögerungszeiten, nämlich die der Transistoren Q7 und Q5 bzw. Q8 und Q6 wirken, bis der Zustand des Flipflops mit den Transistoren Q1 und Q2 verändert ist. Nachteilig ist weiterhin, daß während der Zeit, in der der Steuereingang ein hohes Potential führt und somit kein Schreibvorgang erfolgt, alle Versorgungsströme der Schaltung unverändert bleiben und dadurch der Stromverbrauch vergleichsweise hoch ist.

Aufgabe der Erfindung ist es, eine Schaltungsanordnung für eine Speicherzelle eines D/A-Wandlers anzugeben, die bei Verwendung einer Integrationstechnik für analoge Schaltungen einfach aufgebaut ist und eine geringe Verzögerungszeit aufweist.

Diese Aufgabe wird im wesentlichen dadurch gelöst, daß die Emitter der das Flipflop bildenden Transistoren nicht mit der Bezugsspannung der gesamten Schaltung, d.h. Masse, sondern mit einer etwas höheren weiteren Bezugsspannung verbunden sind, deren minimaler Wert von einer Grenzspannung des zugehörigen Stromgenerators abhängt. Dadurch kann mindestens eine Kreuzkopplung zwischen den das Flipflop bildenden Transistoren direkt, d.h. ohne Widerstand ausgeführt werden, und die Kollektoren der das Flipflop bildenden Transistoren können direkt mit den Basen der den Stromschalter bildenden Transistoren verbunden werden. Außerdem können das Datensignal und das Steuersignal auf wenigstens einen, vorzugsweise zwei Steuertransistoren geführt werden, deren Kollektoren direkt mit den Basen der das Flipflop bildenden Transistoren verbunden sind. Dadurch ist die Anzahl der benötigten Transistoren nur gering, und es werden nur sehr wenige Widerstände, im Extremfall nur ein Widerstand, benötigt, so daß die erfindungsgemäße Schaltungsanordnung nur eine geringe Integrationsfläche benötigt und wegen der geringen Anzahl der direkt gekoppelten Transistoren nur eine geringe Verzögerungszeit aufweist.

Ausgestaltungen der Erfindung sind in den Unteransprüchen gekennzeichnet.

Ausführungsbeispiele der Erfindung werden nachstehend anhand der Zeichnung näher erläutert. Es zeigen
Fig. 3 eine erfindungsgemäße Schaltungsanordnung mit zwei Steuertransistoren,
Fig. 4 schematisch das Layout von drei nebeneinander angeordneten Schaltungsanordnungen nach Fig. 3,
Fig. 5 eine Abwandlung der Schaltungsanordnung nach Fig. 3, in der die Stromschaltertransistoren entgegengesetzte Leitfähigkeit wie die der Transistoren des Flipflops haben,
Fig. 6 eine Schaltungsanordnung mit nur einem Steuertransistor.

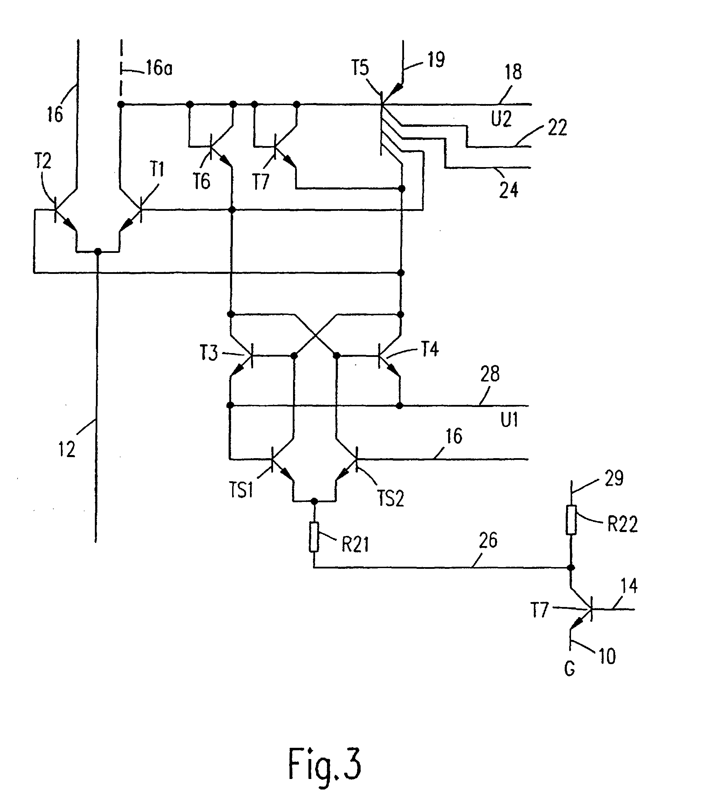

In Fig. 3 sind für das Umschalten eines dem Stromeingang 12 zugeführten Stroms wieder zwei Transistoren T1 und T2 vorgesehen, deren Emitter der zu schaltende Strom zugeführt wird, wobei der Kollektor des Transistors T2 den Stromausgang 16 bildet. Der Kollektor des Transistors T1 ist für die folgende Beschreibung mit der Leitung 18 für die Betriebsspannung verbunden. Das Flipflop ist hier wieder durch zwei kreuzgekoppelte Transistoren T3 und T4 gebildet, bei denen die Basis jedes Transistors mit dem Kollektor des jeweils anderen Transistors direkt verbunden ist. Die Stromversorgung des Flipflops erfolgt über zwei Stromquellen, die durch die Kollektoren eines Multikollektor-Transistors T5 gebildet werden, der eine entgegengesetzte Leitfähigkeit wie die der Transistoren T3 und T4 des Flipflops hat, d.h. in diesem Beispiel ein PNP-Transistor ist. Der Transistor T5 weist zwei weitere Kollektoren auf, von denen über Leitungen 22 und 24 entsprechende Ströme für das Flipflop einer benachbarten Anordnung fließen. Dies hat Vorteile für die Integration, wie später erläutert wird.

Anders als bei der Schaltung nach Fig. 2 sind hier die Emitter der das Flipflop bildenden Transistoren T3 und T4 nicht mit Masse, sondern über eine Leitung 28 mit einer höheren Bezugsspannung U1 verbunden, die vorzugsweise zwischen 1 und 1,5 V liegt. Auf diese Weise ist es möglich, die Basen der Transistoren T1 und T2 des Stromschalters direkt mit den Kollektoren der das Flipflop bildenden Transistoren T3 und T4 zu verbinden. Wesentlich ist, daß der Transistor des in Fig. 1 dargestellten Stromgenerators CG bei beiden Zuständen des Flipflops eine ausreichend hohe Kollektor-Emitter-Spannung Uce erhält. Wenn angenommen wird, daß die mit der Basis des Transistors im Stromgenerator verbundene Leitung 11 in Fig. 1 eine Spannung von 1 V hat, so daß sich an dem Emitterwiderstand des Stromgenerators eine Spannung von etwa 0,3 V ausbildet, und daß die Kollektor-Basis-Spannung des Transistors im Stromgenerator größer Null sein soll, muß die Bezugsspannung U1 auf der Leitung 28 an den Emittern der Transistoren T3 und T4 größer 1 V sein. Ist nun z.B. der Transistor T2 leitend, so liegt seine Basis und damit auch die Basis des Transistors T3 um eine Basis-Emitter-Durchlaßspannung höher als 1 V. Der Emitter des Transistors T3 und damit die Bezugsspannung U2 muß dann mindestens 1 V sein. Unter Berücksichtigung von Toleranzen wird die Bezugsspannung U1 zweckmäßig 1,2 bis 1,5 V gewählt.

Da die Emitter der Transistoren T3 und T4 an der Bezugsspannung U1 liegen, die höher als das Massepotential ist, ist es möglich, zum Einschreiben eines binären Wertes in das Flipflop eine einfache Differenzverstärkerschaltung mit den Steuertransistoren TS1 und TS2 zu verwenden, deren Emitter gemeinsam über einen Widerstand R21 mit einer Steuerleitung 26 verbunden sind. Diese Steuerleitung 26 wird gemeinsam mit den Steuerleitungen aller anderen Stufen von dem Kollektor eines Transistors T7 angesteuert, dessen Emitter mit Masse und dessen Basis mit der Steuerleitung 14 verbunden ist. Wenn der Transistor T7 gesperrt und damit die Spannung auf der Steuerleitung 26 größer als die Bezugsspannung U1 ist, fließt durch die Steuertransistoren TS1 und TS2 kein Strom, und der Zustand des Flipflops wird nicht beeinflußt. Zum Einschreiben eines durch das Signal am Dateneingang 16 bestimmten binären Wertes wird der Transistor T7 leitend geschaltet, und abhängig von dem Signal am Dateneingang 16 ist entweder der Transistor TS1 oder TS2 leitend und sperrt den Transistor T3 oder T4. Der Kollektorstrom des Transistors TS1 bzw. TS2 muß dabei etwa 2 bis 3-fach höher sein als die vom entsprechenden Kollektor des Transistors T5 gelieferten Ströme. Wenn z.B. der Transistor TS1 leitend ist, so wird der Transistor T3 gesperrt, da der Kollektorstrom des Transistors TS1 größer ist als der Kollektorstrom des Transistors T5. Der als Diode geschaltete Transistor T7 bewirkt, daß die Basis des Transistors T3 auf etwa die Bezugsspannung U1 gebracht wird, da Kollektor und Basis des Transistors T7 an die Betriebsspannung U2 angeschlossen sind, die hier den Wert U2=U1+Ube hat. Damit wird verhindert, daß der Transistor TS1 gesättigt wird und dann ein unzulässig hoher Basisstrom fließen könnte. Entsprechendes gilt, wenn das Signal am Dateneingang 16 höher als die Bezugsspannung U1 ist, so daß der Transistor TS2 leitet. Hier wird das Potential am Kollektor des Transistors TS2 durch den als Diode geschalteten Transistor T6 begrenzt.

Während der Speicherphase nach dem Einschreiben, wobei der Transistor T7 gespert ist, fließt durch die Transistoren T6 und T7 nur ein sehr kleiner Leckstrom. Dies wird dadurch erreicht, daß die Betriebsspannung U2 nur um Ube größer ist als die Bezugsspannung U1 und damit an den Transistoren T6 und T7 nur maximal die Spannung Uce=Ube-Ucesat liegt. Während der Speicherphase werden auch nur die beiden Ströme für die Transistoren T3 und T4 benötigt, während nur für den kurzen Einspeichervorgang zusätzlich im Transistor TS1 bzw. TS2 ein etwa 2 bis 3-fach höherer Strom aus der Betriebsspannung U2 benötigt wird. Die Betriebsspannung U2 und die Bezugsspannung U1 müssen nur einmal für sämtliche Speicher erzeugt werden. Auch die Emitter der Transistoren T5 aller Speicher können grundsätzlich an eine gemeinsame Stromquelle angeschlossen werden.

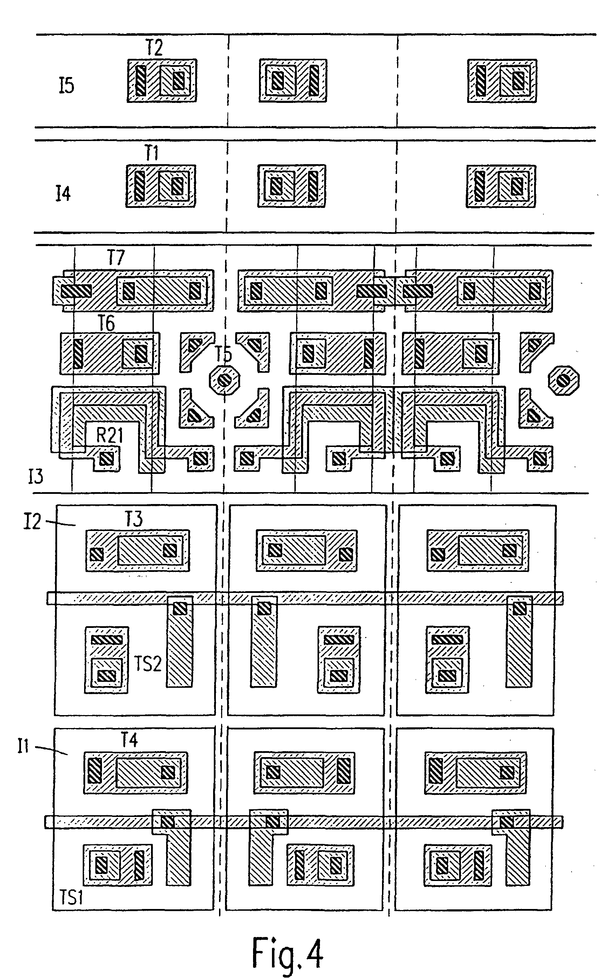

Die Schaltung nach Fig. 3 ist insbesondere wegen der flächengünstigen Integration von Vorteil, da nur wenige Komponenten benötigt werden und außerdem mehrere Komponenten in einer gemeinsamen Insel integriert werden können. Fig. 4 zeigt schematisch ohne Verdrahtungsebenen ein Beispiel für ein Layout mit drei Schaltungsanordnungen nach Fig. 3 nebeneinander. Der Transistor T5 ist ein lateraler PNP-Transistor mit vier separaten Kollektoren, der die Stromversorgung für jeweils zwei Schaltungen übernimmt. Zwei spiegelbildlich aneinander angeordnete Schaltungen sind also jeweils an einen Transistor T5 angeschlossen. In der gleichen Insel I3 liegen weiterhin die als Diode geschalteten Transistoren T6 und T7 sowie der Widerstand R3. Diese Insel I3 kann grundsätzlich mit den jeweils entsprechenden Inseln aller anderen Schaltungen verschmolzen werden. Der Transistor T1 befindet sich zusammen mit den jeweils anderen Transistoren T1 der anderen Schaltungen in einer separaten Insel I4. Diese Insel I4 könnte aber mit der Insel I3 mit den Transistoren T5, T6 und T7 verschmolzen werden, wenn der Kollektor des Transistors T1 an der Betriebsspannung U2 angeschlosen werden soll.

Weiterhin ist eine Insel I5 mit den Transistoren T2 aller Schaltungen erforderlich. Zwei weitere Inseln I1 und I2 sind für die Transistoren TS1 und T4 bzw. TS2 und T3 erforderlich.

Wenn jedoch der D/A-Wandler differentiell arbeiten soll, d.h. der zugeführte analoge Strom wird zwischen zwei getrennten Ausgängen 16 und 16a umgeschaltet, entfällt die Verbindung des Kollektors des Transistors T1 mit der Betriebsspannung U2. Diese Ausführung ist für z.B. Anwendungen mit Multiplizierern von Vorteil. In diesem Falle muß der Transistor T1 zwingend in einer separaten Insel I4 angeordnet werden, wie in Fig. 4 dargestellt ist. In dieser Insel I4 können aber wieder die Transistoren T1 aller Schaltungen des D/A-Wandlers angeordnet werden.

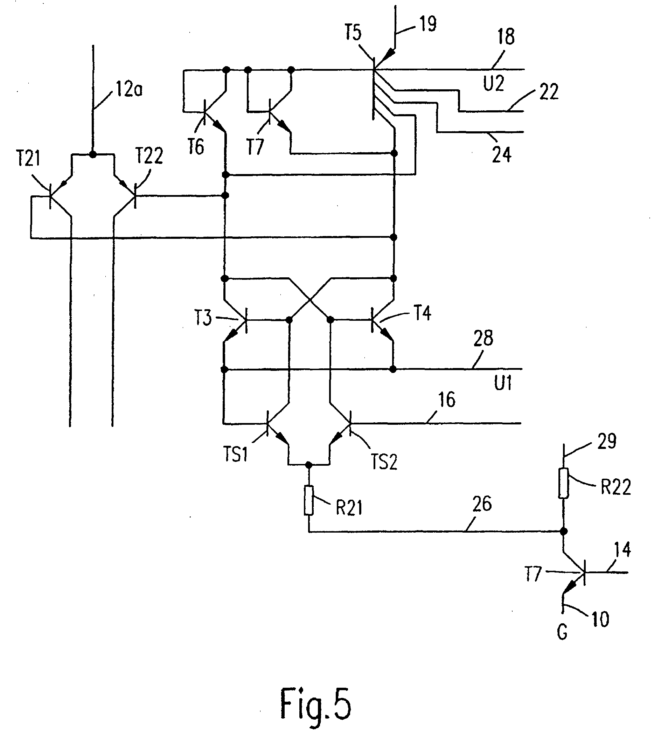

In Fig. 5 ist eine Abwandlung der Schaltung nach Fig. 3 dargestellt, bei der der Stromschalter durch zwei PNP-Transistoren T21 und T22 realisiert ist, deren Basen ebenfalls direkt von den Kollektoren der Transistoren T3 und T4 angesteuert werden. Wenn angenommen wird, daß die Bezugsspannung U1 = 1,5 V ist und die Sättigungsspannung der Transistoren T3 und T4 ca. 0 V sowie als minimale Kollektor-Basis-Spannung UCD der Transistoren T21 und T22 0 V zugelassen wird, dann ist die maximal mögliche Kollektorspannung an den Transistoren T21 und T22 im wesentlichen gleich U1, d.h. gleich 1,5 V. Sollen höhere Werte möglich sein, müssen die Bezugsspannung U1 und die Betriebsspannung U2 und der Maximalwert des Datensignals am Dateneingang 16 entsprechend erhöht werden. Im Layout gemäß Fig. 4 kann der Transistor T21 mit den Transistoren T4 und TS1 sowie der Transistor T22 mit den Transistoren T3 und TS2 unter gewissen Bedingungen in jeweils eine gemeinsame Insel gelegt werden. Die von den Transistoren T3 und T4 ausgelösten parasitären Ströme in den Kollektoren der Transistoren T21 und T22 müssen dabei durch dazwischen liegende p-dotierte Streifen reduziert werden, und der verbleibende Resteinfluß muß innerhalb der Genauigkeitsanforderungen des D/A-Wandlers liegen.

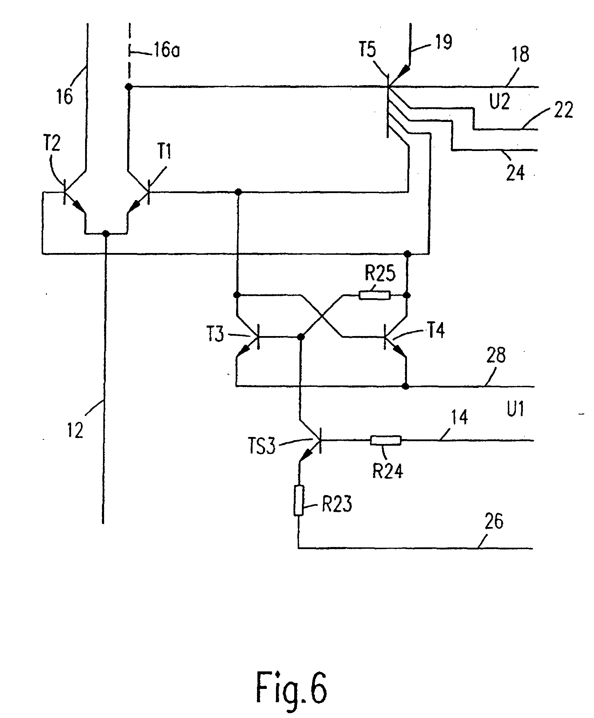

Ein weiteres Ausführungsbeispiel ist in Fig. 6 dargestellt. Darin ist nur ein Steuertransistor TS3 vorhanden, dessen Basis über den Widerstand R24 von der Steuerleitung 14 und dessen Emitter über den Widerstand R23 von dem Datensignal 16 angesteuert wird. Weiterhin ist in der Verbindung zwischen dem Kollektor des Transistors T4 und der Basis des Transistors T3 ein Widerstand R25 angeordnet. Andererseits sind die Kollektoren der Transistoren T3 und T4 nicht mehr über Dioden mit der Betriebsspannung U2 auf der Leitung 18 verbunden. Diese Betriebsspannung U2 kann daher auch um mehr als Ube höher sein als die Bezugsspannung U1 auf der Leitung 28. Diese Schaltung arbeitet wie folgt.

Wenn das Signal am Steuereingang 14 niedrig ist, ist der Transistor TS3 gesperrt und beeinflußt nicht den Zustand des Flipflops. Zum Einschreiben erhält der Steuereingang 14 ein höheres Signal, beispielsweis 4 V oder größer, wenn vorausgesetzt ist, daß die Bezugsspannung U1 auf der Leitung einen Wert von 1,5 V hat. Der Stromfluß im Kollektor des Transistors TS3 hängt nun vom Signal am Dateneingang 16 ab. Wenn dieses Signal hoch ist, fließt durch den Widerstand R23 und den Emitter des Transistors TS3 kein Strom. Der Kollektor des Transistors TS3 liegt je nach Zustand des Flipflops auf nahezu der Bezugsspannung U1 oder um Ube höher, d.h. in jedem Fall auf einer niedrigeren Spannung als die Emitterspannung und die Basisspannung des Transistors TS3. Wenn vorausgesetzt wird, daß das Signal am Dateneingang 16 höher ist als das Signal am Steuereingang 14, wird der Transistor TS3 invers leitend. Damit fließt nun ein Strom vom Kollektor des Transistors TS3 zur Basis des Transistors T3 und durch den Widerstand R25. Wenn angenommen wird, daß vorher der Transistor T4 leitend war, so erhöht sich nun die Basisspannung am Transistor T3 so weit, daß dieser leitend wird und nun seinerseits den Transistor T4 sperrt. Das Flipflop wird so in einen neuen Zustand gebracht. Die Basis des Transistors T3 liegt nun auf einer Spannung von Ud=1,5 V + Ube, und somit liegt an der Basis des Transistors TS3 eine Spannung von 1,5 V + 2Ube, also ca. 3 V. Um dann noch einen ausreichenden Strom durch den Widerstand R24 zu erreichen, muß die Spannung am Steuereingang 14 größer 4 V sein, um Temperatureinflüsse und Streuungen zu berücksichtigen. Weiterhin ist zu berücksichtigen, daß bei dem invers leitenden Transistor TS3 ein Teil des in die Basis fließenden Stromes zum Substrat gelangt. Der verbleibende, im Kollektor fließende Strom muß dann noch so groß sein, daß der Transistor T3 leitend geschaltet werden kann. In einem praktischen Fall muß der Strom durch den Widerstand R24 in diesem Zustand ca. 6-fach bis 10-fach höher sein als die von den Kollektoren des Transistors T5 gelieferten Versorgungsströme.

Für den anderen einzuschreibenden Datenwert ist das Signal am Dateneingang 16 gleich Null. Dann fließt, wenn das Signal am Steuereingang 14 hoch ist, durch den Widerstand R24 ein Basisstrom in den Transistor TS3 und somit auch ein Emitterstrom durch den Widerstand R23. Dadurch wird der Transistor TS3 praktisch gesättigt leitend, und es fließt ein Strom durch den Widerstand R25 in den Kollektor von TS3, der die Basis des Transistors T3 auf eine niedrigere Spannung zieht. Wenn vorher der Transistor T3 leitend war, wird er nun dadurch gesperrt, und der Transistor T4 wird leitend. Damit ist das Flipflop in einen anderen Zustand gebracht. Wenn das Signal am Steuereingang 14 wieder niedrig wird, wird der Transistor TS3 gesperrt, und der Zustand des Flipflops bleibt erhalten.

Diese Ausführungsform hat gegenüber den Schaltungen nach Fig. und Fig. 5 den Vorteil, daß eine Komponente weniger benötigt wird, nämlich nur ein Steuertransistor, und die Betriebsspannung U2 auf der Leitung 18 zu höheren Werten frei gewählt werden kann. Damit kann der Transistor T5 Teil einer PNP-Bank sein, wobei der Emitter dann an eine positive Versorgungsspannung angeschlossen ist. Andererseits ist die Realisierung im Layout in der Weise aufwendiger, daß der Transistor TS3 in einer separaten Insel angeordnet sein muß. Die Transistoren R23 und R24 können in der Insel für den Transistor T5 angeordnet sein, wenn für die Betriebsspannung U2 auf der Leitung 18 eine Spannung gewählt wird, die größer ist als das maximale Steuersignal auf der Leitung 14. Damit ist gegenüber dem in Fig. 4 dargestellten Layout eine Insel mehr, nämlich sechs Inseln erforderlich, wodurch der Vorteil des geringeren Komponentenaufwandes wieder verringert wird.

In der Schaltung nach Fig. 6 können die Transistoren T1 und T2 für den Stromschalter auch wieder als PNP-Transistoren ausgeführt werden.

## Patentansprüche

1. Schaltungsanordnung für eine Speicherzelle eines D/A-Wandlers, mit
einem Dateneingang,
einem Steuereingang,
einem Stromeingang, der mit einem Stromgenerator verbunden ist,
einem Stromschalter aus einem ersten und einem zweiten Transistor, deren Emitter gemeinsam mit dem Stromeingang gekoppelt sind,
einem mit einer Betriebsspannung verbundenen Flipflop mit einem dritten und einem vierten Transistor, deren Basen und Kollektoren kreuzweise gekoppelt sind, deren Kollektoren ferner mit den Basen des zugehörigen ersten bzw. zweiten Transistors gekoppelt sind und deren Emitter mit einer ersten Bezugsspannung verbunden sind,
**dadurch gekennzeichnet,**
**daß** jeder Kollektor des dritten und vierten Transistors (T3, T4) direkt mit der Basis eines anderen von den ersten und zweiten Transistoren (T1, T2, T21, T22) sowie mit je einer Stromquelle (T5) verbunden ist,
**daß** die erste Bezugsspannung (U1) zwischen einer zweiten Bezugsspannung (G) und der Betriebsspannung (U2) liegt und wenigstens um eine erste Differenzspannung von der zweiten Bezugsspannung (G) abweicht, und daß der Dateneingang (16) und der Steuereingang (14) mit wenigstens einem ersten Steuertransistor (TS1, TS2; TS3) gekoppelt sind, dessen Kollektor direkt mit der Basis wenigstens des dritten oder des vierten Transistors (T3, T4) verbunden ist.

2. Schaltungsanordnung nach Anspruch 1, **dadurch gekennzeichnet,**
**daß** die mit den Kollektoren des dritten und vierten Transistors (T3, T4) verbundenen Stromquellen durch die Kollektoren eines mehrere Kollektoren aufweisenden fünften Transistors (T5) mit entgegengesetzter Leitfähigkeit wie die des dritten und vierten Transistors (T3, T4) gebildet sind.

3. Schaltungsanordnung nach Anspruch 1 oder 2, **dadurch gekennzeichnet,**
**daß** ein zweiter Steuertransistor (TS2) vorgesehen ist, daß die Kollektoren beider Steuertransistoren (TS1, TS2) mit der Basis je eines anderen des dritten und vierten Transistors (T3, T4) verbunden sind und die Basen des dritten und vierten Transistors (T3, T4) direkt mit dem Kollektor des jeweils anderen dieser Transistoren (T4, T3) verbunden ist, daß die Emitter des ersten und zweiten Steuertransistors (TS1, TS2) miteinander und über einen ersten Widerstand (R21) mit dem Steuereingang (14) gekoppelt sind und daß die Basis des einen der beiden Steuertransistoren (TS1) mit dem Dateneingang (16) und die Basis des anderen der beiden Steuertransistoren (TS2) mit einer dritten Bezugsspannung (U1) verbunden ist.

4. Schaltungsanordnung nach Anspruch 3, **dadurch gekennzeichnet,**
**daß** die Kollektoren des dritten und vierten Transistors (T3, T4) über je eine Diode (T5, T6) mit der Betriebsspannung (U2) verbunden sind und die Betriebsspannung (U2) um eine Dioden-Durchlaßspannung von der ersten Bezugsspannung (U1) verschieden ist.

5. Schaltungsanordnung nach Anspruch 4, **dadurch gekennzeichnet,**
**daß** die Basis des fünften Transistors (T5) mit der Betriebsspannung (U2) verbunden ist.

6. Schaltungsanordnung nach Anspruch 1 oder 2, **dadurch gekennzeichnet,**
**daß** die Basis des vierten Transistors (T4) direkt mit dem Kollektor des dritten Transistors (T3) und die Basis des dritten Transistors (T3) über einen zweiten Widerstand (R25) mit dem Kollektor des vierten Transistors (T4) und mit dem Kollektor des Steuertransistors (TS3) verbunden ist, dessen Emitter über einen dritten Widerstand (R23) mit dem Dateneingang (16) und dessen Basis über einen vierten Widerstand (R24) mit dem Steuereingang (14) verbunden ist.

7. D/A-Wandler mit mehreren Schaltungsanordnungen nach einem der Ansprüche 2 bis 5, **dadurch gekennzeichnet,**
**daß** der fünfte Transistor (T5) mehr als zwei Kollektoren aufweist und wenigstens zwei Schaltungsanordnungen gemeinsam ist.

## Claims

1. A circuit arrangement for a memory cell of a D/A converter with
a data input,
a control input,
a current input which is connected to a current generator,
a current switch comprising a first and a second transistor whose emitters are jointly coupled to the current input,
a flipflop connected to an operating voltage and comprising a third and a fourth transistor whose bases and collectors are cross-coupled, whose collectors are furthermore coupled to the bases of the associated first and second transistor, respectively, and whose emitters are connected to a first reference voltage,
**characterized in that**
each collector of the third and the fourth transistor (T3, T4) is directly connected to a respective base of the first and the second transistor (T1, T2, T21, T22) and to a current source (T5),
**in that** the first reference voltage (U1) lies between a second reference voltage (G) and the operating voltage (U2) and differs from the second reference voltage (G) by at least a first differential voltage, and **in that** the data input (16) and the control input (14) are coupled at least to a first control transistor (TS1, TS2; TS3) whose collector is directly connected to the base of at least the third or the fourth transistor (T3, T4).

2. A circuit arrangement as claimed in Claim 1, **characterized in that** the current sources connected to the collectors of the third and the fourth transistor (T3, T4) are formed by the collectors of a fifth transistor (T5) which comprises several collectors and which has a conductivity type opposed to that of the third and the fourth transistor (T3, T4).

3. A circuit arrangement as claimed in Claim 1 or 2, **characterized in that** a second control transistor (TS2) is provided, **in that** the collectors of the two control transistors (TS1, TS2) are each connected to a respective base of the third and the fourth transistor (T3, T4), and the bases of the third and the fourth transistor (T3, T4) are directly connected to the collector of the respective other one of these transistors (T4, T3), **in that** the emitters of the first and the second control transistor (TS1, TS2) are coupled to one another and via a first resistor (R21) to the control input (14), and **in that** the base of one of the two control transistors (TS1) is coupled to the data input (16), and the base of the other one of the two control transistors (TS2) is connected to a third reference voltage (U1).

4. A circuit arrangement as claimed in Claim 3, **characterized in that** the collectors of the third and the fourth transistor (T3, T4) are each connected to the operating voltage (U2) via a respective diode (T5, T6), and **in that** the operating voltage (U2) differs from the first reference voltage (U1) by a diode forward voltage.

5. A circuit arrangement as claimed in Claim 4, **characterized in that** the base of the fifth transistor (T5) is connected to the operating voltage (U2).

6. A circuit arrangement as claimed in Claim 1 or 2, **characterized in that** the base of the fourth transistor (T4) is directly connected to the collector of the third transistor (T3), and the base of the third transistor (T3) is connected via a second resistor (R25) to the collector of the fourth transistor (T4) and to the collector of the control transistor (TS3) whose emitter is connected via a third resistor (R23) to the data input (16) and whose base is connected via a fourth resistor (R24) to the control input (14).

7. A D/A converter comprising several circuit arrangements as claimed in any one of the Claims 2 to 5, **characterized in that** the fifth transistor (T5) comprises more than two collectors and is common to at least two circuit arrangements.

## Revendications

1. Circuit pour une cellule de mémoire d'un convertisseur N/A avec une entrée de données, une entrée de commande, une entrée de courant qui est reliée à un générateur de courant, un commutateur de courant composé d'un premier et d'un deuxième transistor dont les émetteurs sont couplés ensemble à l'entrée de courant, une bascule bistable reliée à une tension de service avec un troisième et un quatrième transistors dont les bases et les collecteurs sont couplés en croix, dont les collecteurs sont par ailleurs couplés avec les bases des premier et deuxième transistors correspondants et dont les émetteurs sont reliés à une première tension de référence, **caractérisé en ce que** chaque collecteur des troisième et quatrième transistors (T3, T4) est relié directement à la base d'un autre des premier et deuxième transistors (T1, T2, T21, T22) ainsi qu'à une source de courant respective (T5),
que la première tension de référence (U1) est située entre une deuxième tension de référence (G) et la tension de service (U2) diffère au moins d'une première tension différentielle de la deuxième tension de référence (G) et que l'entrée de données (16) et l'entrée de commande (14) sont couplées à au moins un premier transistor de commande (TS1, TS2, TS3) dont le collecteur est relié directement à la base d'au moins les troisième ou quatrième transistors (T3, T4).

2. Circuit selon la revendication 1, **caractérisé en ce que** les sources de courant reliées aux collecteurs des troisième et quatrième collecteurs (T3, T4) sont formées par les collecteurs d'un cinquième transistor (T5) présentant plusieurs collecteurs avec une conductibilité opposée aux troisième et quatrième transistors (T3, T4).

3. Circuit selon l'une des revendications 1 ou 2 **caractérisé en ce qu'**un deuxième transistor de commande (TS2) est prévu, que les collecteurs des deux transistors de commande (TS1, TS2) sont respectivement reliés à la base d'un autre des troisième et quatrième transistors (T3, T4) et les bases des troisième et quatrième transistors (T3, T4) sont respectivement reliées au collecteur de l'autre de ces transistors (T4, T3), que les émetteurs des premier et deuxième transistors de commande (TS1, TS2) sont couplés entre eux et, par l'intermédiaire d'une première résistance (R21) à l'entrée de commande (14) et que la base d'un deux transistors de commande (TS1) est reliée à l'entrée de données (16) et la base de l'autre des deux transistors de commande (TS2) à une troisième tension de référence (U1).

4. Circuit selon la revendication 3, **caractérisé en ce que** les collecteurs des troisième et quatrième transistors (T3, T4) sont respectivement reliés par l'intermédiaire d'une diode (T5, T6) à la tension de service (U2) et la tension de service (U2) diffère de la première tension de référence (U1) d'une tension de diode à l'état passant.

5. Circuit selon la revendication 4, **caractérisé en ce que** la base du cinquième transistor (T5) est reliée à la tension de service (U2).

6. Circuit selon l'une des revendications 1 ou 2, **caractérisé en ce que** la base du quatrième transistor (T4) est reliée directement au collecteur du troisième transistor (T3) et la base du troisième transistor (T3) par l'intermédiaire d'une deuxième résistance (R25) au collecteur du quatrième transistor (T4) et avec le collecteur du transistor de commande (TS3) dont l'émetteur est relié par l'intermédiaire d'une troisième résistance (R23) à l'entrée de données (16) et sa base par l'intermédiaire d'une quatrième résistance (R24) à l'entrée de commande (14).

7. Convertisseur N/A avec plusieurs agencements de circuits selon l'une des revendications 2 à 5, **caractérisé en ce que** le cinquième transistor (T5) présente plus de eux collecteurs et est commun à au moins deux agencements de circuit.
